# EUROPÄISCHE PATENTSCHRIFT

(11) **EP 0 569 550 B1**
(45) Veröffentlichungstag und Bekanntmachung des Hinweises auf die Patenterteilung: **06.09.1995**
(21) Anmeldenummer: 92907259.3
(22) Anmeldetag: 03.04.1992
(51) Int. Cl.: C23C 2/40, C25D 17/06

(54) **GESTELLSTAB**
SUPPORT ROD
BARRE DE SUPPORT

(30) Priorität: 30.10.1991 DE 9113516 U
(43) Veröffentlichungstag der Anmeldung: 18.11.1993
(73) Patentinhaber: Strecker, Günther, D-7100 Heilbronn-Böckingen (DE)
(72) Erfinder: Strecker, Günther, D-7100 Heilbronn-Böckingen (DE)
(74) Vertreter: Betten & Resch
(86) Internationale Anmeldenummer: DE9200270
(87) Internationale Veröffentlichungsnummer: WO9309259

(56) Entgegenhaltungen:
- EP-A- 0 239 736
- EP-A- 0 254 056
- DE-A- 3 603 062
- DE-U- 9 017 374

## Beschreibung

Die Erfindung betrifft einen Gestellstab zur Tauchgalvanisierung plattenförmiger Gegenstände, insbesondere Leiterplatten, mit Haltevorrichtungen, an denen die Platten durch Einklemmen zwischen einer Anlagefläche und einem in Richtung auf die Anlagefläche hin vorgespannten Federbügel gehalten sind.

Bei einem bekannten Gestellstab dieser Bauart sind die Federbügel in im Gestellstab ausgebildeten Bohrungen schwenkbar angeordnet. In ihrer Klemmposition sind die Federbügel im wesentlichen im rechten Winkel zur Längsrichtung des Gestellstabs ausgerichtet, zum Laden bzw. Entladen der zu beschichtenden bzw. beschichteten Platte werden die bekannten Federbügel angehoben und zur Seite geschwenkt. Nachdem die als Federdraht ausgebildeten Federbügel drehbar in entsprechenden Bohrungen im Gestellstab gelagert sind, besteht aufgrund der Drehung des Federbügels beim Be- und Entladevorgang die Gefahr, daß im Bereich des Lagers die Beschichtung des Gestellstabes verletzt wird. Ein weiterer Nachteil der bekannten Anordnung ist darin zu sehen, daß aufgrund der Ausrichtung des Federbügels in der Klemmposition im wesentlichen senkrecht zum Gestellstab der Klemmbügel mit seinem klemmenden Ende relativ weit in die zu beschichtende Platte hineinragt, so daß der nicht nutzbare Randbereich der Platte vergleichsweise groß ist; in der Praxis beträgt die Breite des nicht nutzbaren Plattenrandes etwa 20 mm. Schließlich gestaltet sich das Verschwenken der Federbügel gemäß dem Stand der Technik vergleichsweise aufwendig, nachdem hier ein relativ langer Bewegungsweg des Federbügels und weiterhin eine Drehbewegung um etwa 90° erforderlich ist.

Bei einer weiteren bekannten Ausführungsform eines Gestellstabs sind die Haltevorrichtungen jeweils als einstückiger Halteblock ausgebildet, und die Halteblöcke weisen Einschnitte zum Einschieben der zu beschichtenden Platte auf, wobei die Platte mittels in den Halteblöcken angebrachter Klemmschrauben fixierbar sind. Bei dieser Anordnung wird insbesondere als nachteilig erachtet, daß die Platten nicht frontal, d.h. in einer Richtung senkrecht zur Plattenebene, Be- und Entladen werden können, ohne daß die an der Warenschiene getragenen Gestellstäbe auseinanderbewegt werden, was jedoch zeitaufwendig und umständlich ist.

Der Erfindung liegt daher in erster Linie die Aufgabe zugrunde, einen verbesserten Gestellstab zu schaffen, der das frontale Be- und Entladen der Platten auf einfache Weise zuläßt, der verschleißarm ist und darüberhinaus eine möglichst große Ausnutzung auch des Randbereichs der Platte zuläßt.

Diese Aufgabe wird erfindungsgemäß im wesentlichen dadurch gelöst, daß der Federbügel als langgestrecktes Bauteil ausgebildet ist, mit seinem einen Ende am Gestellstab bzw. der Haltevorrichtung drehfest befestigt ist, im entspannten Zustand insgesamt unter einem kleinen Winkel von kleiner als 30°, vorzugsweise kleiner als 10° zur Längsrichtung des Gestellstabs - gesehen in der Ebene der Auflagefläche - verläuft und mit seinem freien, mit der Platte in Kontakt befindlichen Ende zwischen einer Klemmposition, in der die Platte zwischen Anlagefläche und freiem Ende des Federbügels geklemmt ist, und einer Freigabeposition, in der der Federbügel insgesamt - gesehen in der Ebene der Anlagefläche - neben der Platte liegt, bewegbar ist.

Nachdem im Fall der vorliegenden Erfindung der Federbügel in der Freigabeposition vollständig neben der Platte liegt, ist ein frontales Be- und Entladen der Platte gewährleistet. Da der Federbügel insgesamt als langgestrecktes Bauteil ausgebildet ist und sich im wesentlichen parallel zum Gestellstab bzw. nur unter einem kleinen Winkel hierzu erstreckt, ist der Bewegungsweg des Federbügels nur sehr kurz und darüberhinaus im wesentlichen linear, was die Betätigung des Federbügels vereinfacht und beschleunigt. Nachdem schließlich das eine Ende des Federbügels drehfest fixiert ist, werden die beim Stand der Technik auftretenden Abnutzungserscheinungen vermieden, und zudem ist eine entspannte Position des Federbügels definiert, die vorzugsweise entweder die Freigabeposition oder die Klemmposition des Federbügels ist. Für die andere Position, in der sich der Federbügel unter Vorspannung befindet, ist vorzugsweise eine Rasteinrichtung vorgesehen, die im einfachsten Fall eine Rastvertiefung oder ein seitlicher Anschlag für das klemmende Ende des Federbügels sein kann.

Nachdem der langgestreckte Federbügel im wesentlichen parallel bzw. tangential zum Plattenrand verläuft, kann erreicht werden, daß der Federbügel in seiner Klemmposition nur am äußersten Rand der Platte angreift, so daß gegenüber dem bekannten Stand der Technik eine sehr viel bessere Ausnutzung der Platte möglich ist; der im Falle der vorliegenden Erfindung nicht nutzbare Plattenrand beträgt beim speziellen Ausführungsbeispiel lediglich etwa 5 mm gegenüber 20 mm beim Stand der Technik.

In bevorzugter Weiterbildung der Erfindung ist vorgesehen, daß an einem Stab mehrere Halteblöcke in Längsrichtung äquidistant verteilt angeordnet sind, wobei der Abstand der Halteblöcke untereinander im wesentlichen der Länge der Federbügel entspricht, und daß jeder Federbügel mit seinem drehfesten Ende an einem Halteblock befestigt ist und mit seinem freien Ende an dem darauffolgenden Halteblock aufliegt.

Im einzelnen umfasssen die Halteblöcke vorzugsweise jeweils einen äusseren, dem Stab abgewandten Abschnitt, der die Anlagefläche aufweist, sowie einen sich hieran in Richtung zum Stab hin anschließenden weiteren Abschnitt, der der Freigabeposition des Federbügels entspricht und vorzugsweise als Rastvertiefung für den Federbügel ausgebildet sein kann. Der Federbügel ist dann zwischen Freigabeposition und Klemmposition lediglich um ein paar Millimeter zu verschieben, wobei er in der Klemmposition aufgrund seiner Vorspannung und in der Freigabeposition aufgrund der Rastvertiefung gehalten wird.

Weitere vorteilhafte Merkmale der Erfindung ergeben sich aus den übrigen Unteransprüchen sowie aus der nachfolgenden Beschreibung, in der ein bevorzugtes Ausführungsbeispiel der Erfindung anhand der Zeichnung näher beschrieben ist. In der Zeichnung zeigen:
- Fig. 1: eine Teilansicht einer Vorrichtung zum Tauchgalvanisieren bestehend aus einem Warenträger und mehreren, hieran befestigten erfindungsgemäßen Gestellstäben, in schematischer Darstellung,
- Fig. 2: eine vergrößerte Detailansicht eines Gestellstabs gemäß Fig. 1,
- Fig. 3: eine Seitenansicht des Gestellstabs gemäß Fig. 2 in Richtung des Pfeiles III, und
- Fig. 4: einen Schnitt durch den Gestellstab gemäß Fig. 2 in Richtung der Pfeile IV-IV.

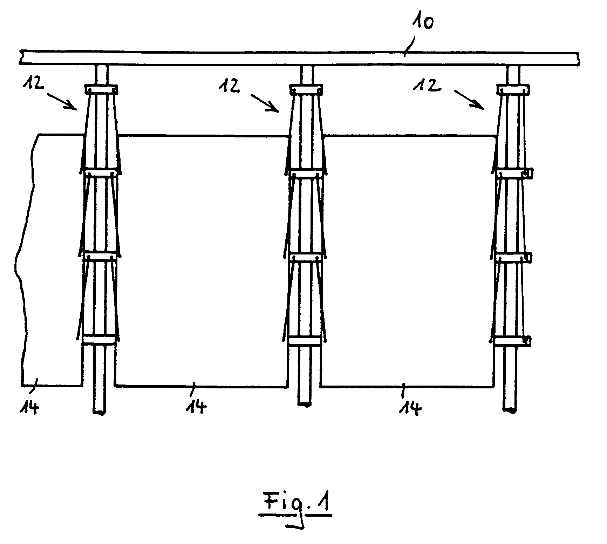

Die Vorrichtung gemäß Fig. 1 umfaßt einen horizontal angeordneten Träger 10, die sogenannte Warenschiene, und mehrere, hieran befestigte, vertikale Gestellstäbe 12, die an der Warenschiene 10 lösbar oder unlösbar und ggf. auch in Richtung der Warenschiene 10 verschieblich befestigt sein können. Zwischen benachbarten Gestellstäben 12 werden über die weiter unten zu beschreibenden Haltevorrichtungen die zu beschichtenden Platten 14, beispielsweise Leiterplatten, lösbar gehalten. Im folgenden wird auf die Fig. 2 bis 4 Bezug genommen, welche die Gestellstäbe in größerem Detail darstellen.

Der Gestellstab 12 umfaßt einen Stab 16 mit kreisrundem Querschnitt, an dem mehrere Halteblöcke 18 in Längsrichtung des Stabes vorzugsweise unter jeweils gleichen Abständen beabstandet angeordnet sind. Die Halteblöcke 18 sind im Falle des Ausführungsbeispiels über eine hierin ausgebildete Durchgangsbohrung auf den Stab 16 aufgeschoben und hieran angeschweißt. Jeder Halteblock 18 ist bezüglich der Mittelebene 20 des Stabes 16 symmetrisch ausgebildet, nachdem die Gestellstäbe, wie aus Fig. 1 ersichtlich beidseitig zum Tragen von Platten 14 ausgebildet sind.

Jeder Halteblock 18 weist einen bezüglich der Längsachse 22 des Stabes 16 außenliegenden Abschnitt auf, an dem eine ebene Anlagefläche 24 ausgebildet ist, die senkrecht zur Mittelebene 20 verläuft, also in der Ebene der Darstellung gemäß Fig. 1 oder Fig. 2 (Plattenebene). An dieser Anlagefläche liegt die am Gestellstab befestigte Platte 14 flächig an. An die Anlagefläche 24 schließt sich in Richtung zur Längsachse 22 eine Anschlagfläche 26 an, die parallel zur Mittelebene 20 verläuft, und als Anschlag für die zu beschichtenden Platten 14 dient.

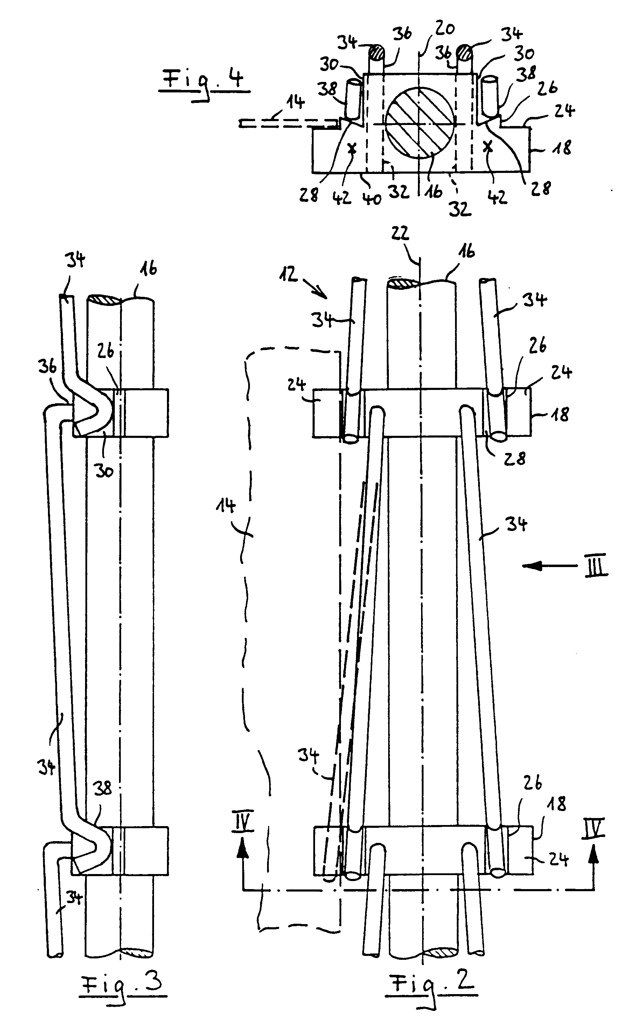

In Richtung zur Mittelachse anschließend an die Anschlagfläche 26 ist eine schiefe Ebene 28 ausgebildet, die in der Darstellung gemäß Fig. 4 in der Richtung zur Mittelebene 20 hin nach unten geneigt ist und im Zusammenwirken mit der sich in Richtung zur Mittelebene 20 hieran anschließenden, parallel zur Anschlagfläche 26 angeordneten Fläche 30 als Rastvertiefung für das freie Ende der weiter unten zu beschreibenden Federbügel dient.

Eine Durchgangsbohrung 32 ist im Halteblock 18 zwischen der Fläche 30 und dem Stab 16 senkrecht zur Ebene der Anlagefläche 24 ausgebildet und dient zur Aufnahme des rückwärtigen, abgewinkelten Schenkels 36 eines insgesamt mit 34 bezeichneten Federbügels. Der abgewinkelte Schenkel 36 ist an seinem unteren Ende mit der Unterseite 40 des Halteblocks 18 verschweißt, so daß der Federbügel 34 insgesamt über den abgewinkelten Schenkel 36 drehfest mit dem Halteblock 18 verbunden ist, aufgrund seiner Federspannung jedoch um ein gewisses Maß federnd verschwenkt werden kann.

Der Federbügel 34 ist insgesamt als langgestrecktes Bauteil ausgebildet, welches sich, wie insbesondere aus Figur 2 deutlich wird, im wesentlichen in Richtung der Längsachse 22 des Stabes 16 erstreckt bzw. hiermit einen nur kleinen Winkel einschließt. Das dem abgewinkelten Schenkel 36 gegenüberliegende, freie Ende des Federbügels 34 ist als Nase 38 ausgebildet und liegt an dem jeweils nächsten Halteblock 18 unter Federvorspannung an, und zwar entweder im Bereich der Anlagefläche 24 oder im Bereich der schiefen Ebene 28. Der Federbügel ist mit seinem abgewinkelten Schenkel 36 in einer solchen Lage am jeweiligen Halteblock 18 fixiert, daß er, in der Ebene gemäß Fig. 2 gesehen, ohne Vorspannung mit seiner Nase 38 im Bereich der Anlagefläche 24 liegt, wie dies in Fig. 2 gestrichelt dargestellt ist. "Ohne Vorspannung" oder "entspannte Position" soll hier bedeuten, daß die in der Zeichenebene liegende Komponente der Vorspannung gleich Null ist; senkrecht hierzu ist selbstverständlich stets eine Vorspannung vorhanden. In dieser Klemmposition des Federbügels klemmt die Nase 38 des Federbügels aufgrund der senkrecht zur Zeichenebene gemäß Fig. 2 wirkenden Vorspannung des Federbügels die in Position befindliche Platte 14 zwischen sich und der Anlagefläche 24 fest und hält somit die Platte 14 - zusammen mit weiteren Haltevorrichtungen - in Position. Zum Be- und Entladen der Platte wird der Federbügel unter leichtem Anheben und Verschwenken in Richtung zur Längsachse 22 entgegen der Federkraft in die in den Fig. 2 bis 4 dargestellte Freigabeposition verschwenkt, in der der Federbügel aufgrund der hier ausgebildeten Rastung verbleibt, bis er bei Bedarf wieder in die Klemmposition verschwenkt wird.

Das vorstehend beschriebene Ausführungsbeispiel ist lediglich illustrativ und in keiner Weise beschränkend. Zahlreiche Modifikationen sind denkbar. So muß beispielsweise der Federbügel 34 keine abgewinkelten Schenkel aufweisen, vielmehr kann die Bohrung im Halteblock 18 auch parallel zur Längsachse 22 des Stabes 16 vorgesehen sein, wie dies in Fig. 4 durch die Bezugsziffer 42 angedeutet ist, und es kann, insbesondere auch in diesem Fall, der Federbügel 34 in seiner entspannten Position im wesentlichen parallel zur Längsachse 22 verlaufen und die Freigabeposition definieren, wobei in diesem Fall für die Klemmposition ein geeigneter Anschlag o.dgl. vorzusehen ist; beispielsweise kann hierfür die Anschlagfläche 26 genutzt werden, wenn deren Höhe ausreichend größer ist als die Dicke der zu klemmenden Platten 14.

## Patentansprüche

1. Gestellstab zur Tauchgalvanisierung plattenförmiger Gegenstände, insbesondere Leiterplatten, mit Haltevorrichtungen, an denen die Platten durch Einklemmen zwischen einer Anlagefläche und einem in Richtung auf die Anlagefläche hin vorgespannten Federbügel gehalten sind,
dadurch gekennzeichnet,
daß der Federbügel (34) als langgestrecktes Bauteil ausgebildet ist, mit seinem einen Ende (36) am Gestellstab (12) bzw. der Haltevorrichtung (18) drehfest befestigt ist,
im entspannten Zustand insgesamt unter einem Winkel von kleiner als 30° zur Längsrichtung des Gestells - gesehen in der Ebene der Anlagefläche - verläuft, und
mit seinem freien, mit der Platte (14) in Kontakt tretenden Ende (38) zwischen einer Klemmpostion, in der die Platte zwischen Anlagefläche und freiem Ende des Federbügels geklemmt ist, und einer Freigabeposition, in der der Federbügel - gesehen in der Ebene der Anlagefläche - insgesamt neben der Platte liegt, bewegbar ist.

2. Gestellstab nach Anspruch 1, dadurch gekennzeichnet, daß entweder die Freigabeposition oder die Klemmposition die - in der Ebene der Anlagefläche (24) gesehen - entspannte Position des Federbügels (34) ist.

3. Gestellstab nach Anspruch 2, dadurch gekennzeichnet, daß eine Rasteinrichtung (22) zum Fixieren des Federbügels (34) in der anderen, vorgespannten Position vorgesehen ist.

4. Gestellstab nach Anspruch 2 oder 3, dadurch gekennzeichnet, daß die Klemmposition die entspannte Position des Federbügels (34) ist.

5. Gestellstab nach einem der vorhergehenden Ansprüche, dadurch gekennzeichnet, daß der Federbügel (34) im entspannten Zustand - in der Ebene der Anlagefläche (24) gesehen - mit der Längsrichtung (22) des Gestellstabs (12) einen Winkel von weniger als 10° einnimmt.

6. Gestellstab nach einem der vorhergehenden Ansprüche, dadurch gekennzeichnet, daß an einem Stab (16) mehrere Halteblöcke (18) in Längsrichtung (22) des Stabes gesehen äquidistant verteilt angeordnet sind, wobei der Abstand der Halteblöcke (18) untereinander im wesentlichen der Länge der Federbügel (34) entspricht, und daß jeder Federbügel (34) mit seinem drehfesten Ende (36) an einem Halteblock befestigt ist und mit seinem freien Ende (38) an dem darauffolgenden Halteblock aufliegt.

7. Gestellstab nach Anspruch 6, dadurch gekennzeichnet, daß die Halteblöcke (18) jeweils einen äußeren, dem Stab (16) abgewandten Abschnitt umfassen, der die Anlagefläche (24) aufweist, sowie einen sich hieran in Richtung zum Stab hin anschließenden weiteren Abschnitt, der der Freigabeposition des Federbügels (34) entspricht.

8. Gestellstab nach Anspruch 7, dadurch gekennzeichnet, daß der weitere Abschnitt als Rastvertiefung für den Federbügel (34) ausgebildet ist.

9. Gestellstab nach Anspruch 7 oder 8, dadurch gekennzeichnet, daß zwischen der Anlagefläche (24) und dem weiteren Abschnitt ein Anschlag (26) für die Platten (14) ausgebildet ist.

10. Gestellstab nach einem der Ansprüche 6 bis 9, dadurch gekennzeichnet, daß die Halteblöcke (18) bezüglich einer Mittelebene (20) des Stabes (16) spiegelsymmetrisch ausgebildet sind.

## Claims

1. Rack bar for the hot-dip galvanizing of plate-shaped articles, in particular printed circuit boards, with holding devices at which the plates are retained by clamping between a contact surface and a spring clip preloaded in the direction of the contact surface,
characterised in that
the spring clip (34) is formed as an elongated component, with one end (36) attached in a torsionally rigid manner to the rack bar (12) or the holding device (18), respectively,
and which in the unloaded condition runs generally at an angle of less than 30° to the longitudinal direction of the rack - as viewed in the plane of the contact surface, and with its free end (38) in contact with the plate (14) being able to move between a clamped position in which the plate is clamped between the contact surface and the free end of the spring clip, and a released position in which the spring clip generally lies next to the plate - as viewed in the plane of the contact surface.

2. Rack bar according to Claim 1, characterised in that the unloaded position of the spring clip (34) is either the released position or the clamped position - as viewed in the plane of the contact surface (24).

3. Rack bar according to Claim 2, characterised in that a locking device (22) for locking the spring clip (34) in the other preloaded position is provided.

4. Rack bar according to Claim 2 or 3, characterised in that the clamping position is the unloaded position of the spring clip (34).

5. Rack bar according to one of the preceding Claims, characterised in that in the unloaded condition of the spring clip (34) - as viewed in the plane of the contact surface (24), the spring clip (34) makes an angle of less than 10° with the longitudinal direction (22) of the rack bar (12).

6. Rack bar according to one of the preceding Claims, characterised in that several retaining blocks (18) are distributed equidistantly along one bar (16) - as viewed in the longitudinal direction (22) of the bar, the distance between the retaining blocks (18) essentially corresponding to the length of the spring clip (34), and that each spring clip (34) is attached to a retaining block by its torsionally rigid end (36) and its free end (38) rests upon the following retaining block.

7. Rack bar according to Claim 6, characterised in that each of the retaining blocks (18) incorporates an outer section which faces away from the rod (16) and has the contact surface (24), as well as a further section lying adjacent to it in the direction of the rod, which corresponds to the released position of the spring clip (34).

8. Rack bar according to Claim 7, characterised in that the further section is constructed as a locking recess for the spring clip (34).

9. Rack bar according to Claim 7 or 8, characterised in that a stop (26) for the plates (14) is constructed between the contact surface (24) and the further section.

10. Rack bar according to one of the Claims 6 to 9, characterised in that the retaining blocks (18) are constructed in a mirror-symmetrical manner with respect to the central plane (20) of the bar (16).

## Revendications

1. Barre de support pour la galvanisation par immersion d'objets en forme de plaque, en particulier de cartes imprimées, comportant des dispositifs de retenue sur lesquels les plaques sont maintenues par blocage entre une surface d'appui et un étrier à ressort précontraint en direction de la surface d'appui,
caractérisée par le fait
que l'étrier à ressort (34) est réalisé sous forme de pièce allongée, est fixé, sans possibilité de rotation, par l'une (36) de ses extrémités sur la barre de support (12) ou le dispositif de retenue (18),
forme, lorsqu'il est relâché, globalement un angle inférieur à 30° par rapport à la direction longitudinale du support, vu dans le plan de la surface d'appui, et
peut être déplacé avec son extrémité libre (38) entrant en contact avec la plaque (14), entre une position de blocage dans laquelle la plaque est bloquée entre la surface d'appui et l'extrémité libre de l'étrier à ressort et une position de déblocage dans laquelle l'étrier à ressort se trouve globalement à côté de la plaque, vu dans le plan de la surface d'appui.

2. Barre de support selon la revendication 1, caractérisée par le fait que soit la position de déblocage soit la position de blocage est, vu dans le plan de la surface d'appui (24), la position relâchée de l'étrier à ressort (34).

3. Barre de support selon la revendication 2, caractérisée par le fait qu'il est prévu un dispositif d'arrêt (22) pour fixer l'étrier à ressort (34) dans l'autre position précontrainte.

4. Barre de support selon la revendication 2 ou 3 caractérisée par le fait que la position de blocage est la position relâchée de l'étrier à ressort (34).

5. Barre de support selon l'une des revendications précédentes, caractérisé par le fait que l'étrier à ressort (34) forme à l'état relâché, vu dans le plan de la surface d'appui (24), un angle inférieur à 10° avec la direction longitudinale (22) de la barre de support (12).

6. Barre de support selon l'une des revendications précédentes, caractérisée par le fait que plusieurs blocs de retenue (18) sont disposés sur une barre (16) en étant répartis à égales distances dans la direction longitudinale (22) de ladite barre, la distance entre les blocs de retenue (18) correspondant sensiblement à la longueur de l'étrier à ressort (34) et que chaque étrier à ressort (34) est fixé par son extrémité (36) immobilisée en rotation sur un bloc de retenue et repose par son extrémité libre (38) sur le bloc de retenue suivant.

7. Barre de support selon la revendication 6, caractérisée par le fait que les blocs de retenue (18) comprennent respectivement une section extérieure qui est tournée à l'opposé de la barre (16) et comporte la surface d'appui (24) ainsi qu'une autre section qui s'y raccorde en direction de la barre et correspond à la position de déblocage de l'étrier à ressort (34).

8. Barre de support selon la revendication 7, caractérisée par le fait que l'autre section est réalisée sous forme de creux d'encliquetage pour l'étrier à ressort (34).

9. Barre de support selon la revendication 7 ou 8, caractérisée par le fait qu'une butée (26) pour les plaques (14) est réalisée entre la surface d'appui (24) et l'autre section.

10. Barre de support selon l'une des revendications 6 à 9, caractérisée par le fait que les blocs de retenue (18) sont agencés symétriquement par rapport au plan médian (20) de la barre (16).
